# EUROPEAN PATENT APPLICATION

(11) **EP 3 965 538 A1**
(43) Date of publication of application: **09.03.2022**
(21) Application number: 20831732.1
(22) Date of filing: 09.06.2020
(51) Int. Cl.: H05K 5/02, H01Q 21/06, H01Q 5/20

(54) **HOUSING ASSEMBLY, ANTENNA APPARATUS AND ELECTRONIC DEVICE**

(30) Priority: 28.06.2019 CN 201910576465
(71) Applicant: GUANGDONG OPPO MOBILE TELECOMMUNICATIONS CORP., LTD., Dongguan, Guangdong 523860 (CN)
(72) Inventor: JIA, Yuhu, Dongguan, Guangdong 523860 (CN)
(74) Representative: Taor, Simon Edward William
(86) International application number: PCT/CN2020/095212
(87) International publication number: WO 2020/259282

(57) **Abstract**

A housing assembly, an antenna device, and an electronic device are provided. The housing assembly includes a dielectric substrate, a bearing layer, and a coupling structure. The dielectric substrate has a first transmittance to a radio frequency (RF) signal in a preset frequency band. The bearing layer is stacked with the dielectric substrate. The coupling structure is disposed at the bearing layer. An orthographic projection of the coupling structure on the dielectric substrate at least partially covers the dielectric substrate. The coupling structure includes one or more array layers of coupling elements. The array layer has resonance characteristic s in the preset frequency band. The housing assembly has a second transmittance to the RF signal in the preset frequency band in a region corresponding to the coupling structure. The second transmittance is greater than the first transmittance. In implementations of the disclosure, the housing assembly has different transmittance to the RF signal at different regions. In a case that the housing assembly is applied to an antenna, the radiation performance of the antenna is improved.

## Description

### TECHNICAL FIELD

This disclosure relates to the field of electronic technology, and more particularly to a housing assembly, an antenna device, and an electronic device.

### BACKGROUND

Due to the high carrier frequency and the large bandwidth, millimeter waves are the main means to realize the ultra-high data transmission rate of the fifth generation (5G). At present, various internationally well-known mobile terminal equipment manufacturers have planned to implement 5G functions as the standard configuration of their new generation mobile terminal products. In related technologies, a dielectric substrate has a significant effect on the radiation performance of an antenna device facing the dielectric substrate.

### SUMMARY

A housing assembly, an antenna device, and an electronic device are provided, so as to decrease an effect of the housing assembly on the radiation performance of the electronic device and the antenna device.

A housing assembly is provided. The housing assembly includes a dielectric substrate, a bearing layer, and a coupling structure. The dielectric substrate has a first transmittance to a radio frequency (RF) signal in a preset frequency band. The bearing layer is stacked with the dielectric substrate. The coupling structure is disposed at the bearing layer, where an orthographic projection of the coupling structure on the dielectric substrate at least partially covers the dielectric substrate. The coupling structure includes one or more array layers of coupling elements. The array layer has resonance characteristics in the preset frequency band. The housing assembly has a second transmittance to the RF signal in the preset frequency band in a region corresponding to the coupling structure, the second transmittance is greater than the first transmittance.

An antenna device is further provided. The antenna device includes an antenna module and the housing assembly of any of the above implementations. The antenna module is spaced apart from the coupling structure and includes at least one antenna radiator. The coupling structure is at least partially located within a preset direction range in which the antenna radiator emits and receives the RF signal, to match a frequency of the RF signal.

An electronic device is further provided. The electronic device includes a mainboard, an antenna module, and the housing assembly of any of the above implementations. The mainboard is received in the housing assembly. The housing assembly defines an accommodating space at one side of the housing assembly facing the coupling structure. The antenna module is received in the accommodating space and electrically coupled to the mainboard. The antenna module includes at least one antenna radiator. The mainboard is configured to control the antenna radiator to emit and receive RF signals which pass through the housing assembly.

### BRIEF DESCRIPTION OF THE DRAWINGS

To describe technical solutions in implementations of the disclosure more clearly, the following briefly introduces the accompanying drawings required for describing the implementations. Apparently, the accompanying drawings in the following description only illustrate some implementations of the disclosure. Those of ordinary skill in the art may also obtain other drawings based on these accompanying drawings without creative efforts.
FIG. 1 is a schematic structural view of a housing assembly provided in an implementation of the disclosure.
FIG. 2 is a partial schematic structural view of a housing assembly provided in an implementation of the disclosure.
FIG. 3 is a schematic structural view of the housing assembly of FIG. 2 along A-A.
FIG. 4 is a schematic structural view of a housing assembly provided in another implementation of the disclosure along A-A.
FIG. 5 is a partial schematic structural view of a housing assembly provided in another implementation of the disclosure.
FIG. 6 is a schematic structural view of a first array layer of the housing assembly of FIG. 5.
FIG. 7 is a schematic structural view of a second array layer of the housing assembly of FIG. 5.
FIG. 8 is a schematic structural view of a housing assembly provided in to another implementation of the disclosure along A-A.
FIG. 9 is a schematic structural view of an antenna device provided in an implementation of the disclosure.
FIG. 10 is a schematic structural view of an antenna module provided in an implementation of the disclosure.
FIG. 11 is a top view of an antenna module provided in an implementation of the disclosure.
FIG. 12 is a schematic structural view of a housing assembly provided in another implementation of the disclosure along A-A.
FIG. 13 is a schematic structural view of an antenna module provided in another implementation of the disclosure.
FIG. 14 is a schematic structural view of an antenna module provided in another implementation of the disclosure.
FIG. 15 is a top view of an antenna module provided in another implementation of the disclosure.
FIG. 16 is a schematic structural view of an antenna module provided in another implementation of the disclosure.
FIG. 17 is a schematic structural view of an antenna module provided in another implementation of the disclosure.
FIG. 18 is a top view of a feed ground layer of FIG. 17.
FIG. 19 is a schematic structural view of an electronic device provided in an implementation of the disclosure.
FIG. 20 is a schematic structural view of an electronic device provided in another implementation of the disclosure.
FIG. 21 is a schematic structural view of an electronic device provided in another implementation of the disclosure.
FIG. 22 is a schematic structural view of an electronic device provided in another implementation of the disclosure.
FIG. 23 is a schematic structural view of an electronic device provided in another implementation of the disclosure.
FIG. 24 is a schematic structural view of an electronic device provided in another implementation of the disclosure.
FIG. 25 is a schematic diagram of S-parameter curves of a 2×2 antenna module in free space.
FIG. 26 is a schematic diagram of S-parameter curves of a 2×2 antenna module under a conventional glass battery cover.
FIG. 27 is a schematic diagram of S-parameter curves of a 2×2 antenna module under a housing assembly.
FIG. 28 is a schematic diagram of a gain curve of a 2×2 antenna module under a housing assembly.

### DETAILED DESCRIPTION

Technical solutions in the implementations of the disclosure will be described clearly and completely hereinafter with reference to the accompanying drawings in the implementations of the disclosure. Apparently, the described implementations are merely some rather than all implementations of the disclosure. All other implementations obtained by those of ordinary skill in the art based on the implementations of the disclosure without creative efforts shall fall within the protection scope of the disclosure.

According to implementations of the disclosure, a housing assembly is provided. The housing assembly includes a dielectric substrate, a bearing layer, and a coupling structure. The dielectric substrate has a first transmittance to a radio frequency (RF) signal in a preset frequency band. The bearing layer is stacked with the dielectric substrate. The coupling structure is disposed at the bearing layer, where an orthographic projection of the coupling structure on the dielectric substrate at least partially covers the dielectric substrate. The coupling structure includes one or more array layers of coupling elements.

The array layer has resonance characteristics in the preset frequency band. The housing assembly has a second transmittance to the RF signal in the preset frequency band in a region corresponding to the coupling structure, the second transmittance is greater than the first transmittance.

In an implementation, the coupling structure includes one array layer disposed at the bearing layer to increase a transmittance of the housing assembly to the RF signal in the preset frequency band.

In an implementation, the coupling structure includes a first array layer and a second array layer spaced apart from the first array layer. The first array layer and the second array layer are each disposed at a respective one of two opposite sides of the bearing layer. The first array layer is closer to the dielectric substrate than the second array layer.

In an implementation, a projection of the first array layer on the bearing layer at least partially does not overlap with a projection of the second array layer on the bearing layer.

In an implementation, the first array layer defines a through hole, a projection of the second array layer on the first array layer falls into the through hole.

In an implementation, the through hole is in a shape of circle, oval, square, triangle, rectangle, hexagon, ring, cross, or Jerusalem cross.

In an implementation, the first array layer is a square patch, and the second array layer is a circular patch. The first array layer has a side length of 2.2 mm. The through hole is a circular hole and has a radius of 1 mm. The second array layer has a radius of 0.8 mm. The bearing layer has a thickness of 0.2 mm. The dielectric substrate has a thickness of 0.55 mm.

In an implementation, the housing assembly further includes an adhesive member disposed between the dielectric substrate and the bearing layer. The adhesive member fixedly connects the dielectric substrate to the bearing layer.

According to implementations of the disclosure, an antenna device is further provided. The antenna device includes an antenna module and the housing assembly of any of the above implementations. The antenna module is spaced apart from the coupling structure and includes at least one antenna radiator. The coupling structure is at least partially located within a preset direction range in which the antenna radiator emits and receives the RF signal, to match a frequency of the RF signal.

In an implementation, the antenna radiator is disposed at one side of the coupling structure away from the dielectric substrate. The RF signal after frequency matching by the coupling structure is capable of penetrating the dielectric substrate to radiate in a direction away from the antenna radiator.

In an implementation, the antenna radiator has a first feed point and a second feed point. The first feed point is configured to feed a first current signal to the antenna radiator. The first current signal is used to excite the antenna radiator to resonate in a first frequency band to emit and receive the RF signal in the first frequency band. The second feed point is configured to feed a second current signal to the antenna radiator. The second current signal is used to excite the antenna radiator to resonate in a second frequency band. The first frequency band is different from the second frequency band.

In an implementation, the array layer includes a first sub-array layer and a second sub-array layer. The first sub-array layer defines a first through hole. The second sub-array layer defines a second through hole. The first sub-array layer and the second sub-array layer are both located within the preset direction range in which the antenna radiator emits and receives the RF signal. The first through hole and the second through hole are different in size. The RF signal emitted by the antenna radiator after passing through the first through hole has a bandwidth different from that of the RF signal emitted by the antenna radiator after passing through the second through hole.

In an implementation, the first through hole has a radial size greater than the second through hole. The RF signal emitted by the antenna radiator after passing through the first through hole has a bandwidth greater than that of the RF signal emitted by the antenna radiator after passing through the second through hole.

In an implementation, the antenna device further includes a support plate, an RF chip, and an RF line. The antenna radiator is disposed on a surface of the support plate close to the coupling structure. The RF chip is disposed on a surface of the support plate away from the coupling structure. The RF line electrically couples the RF chip with the antenna radiator.

In an implementation, the support plate defines a limiting hole, and the RF line is located in the limiting hole.

In an implementation, the support plate defines multiple metallized vias arranged around the antenna radiator to isolate two adjacent antenna radiators.

In an implementation, the antenna device further includes a support plate, an RF chip, a feed ground layer, and a feed line. The antenna radiator is disposed on a surface of the support plate close to the coupling structure. The RF chip is disposed on a surface of the support plate away from the coupling structure. The feed ground layer is located between the support plate and the RF chip and serves as a ground electrode of the antenna radiator. The feed line is disposed between the RF chip and the feed ground layer. The feed line is electrically coupled to the RF chip. The feed ground layer defines an aperture. A projection of the feed line on the feed ground layer at least partially falls into the aperture. The feed line is configured to couple and feed the antenna radiator via the aperture.

In an implementation, a distance between the coupling structure and the antenna module ranges from 0.5 mm to 2 mm.

According to implementations of the disclosure, an electronic device is provided. The electronic device includes a mainboard, an antenna module, and the housing assembly of any of the above implementations. The mainboard is received in the housing assembly. The housing assembly defines an accommodating space at one side of the housing assembly facing the coupling structure. The antenna module is received in the accommodating space and electrically coupled to the mainboard. The antenna module includes at least one antenna radiator. The mainboard is configured to control the antenna radiator to emit and receive RF signals which pass through the housing assembly.

In an implementation, the electronic device further includes a battery cover, where the battery cover acts as the dielectric substrate, the battery cover is made of one or more of plastic, glass, sapphire, and ceramic.

In an implementation, the battery cover includes a rear plate and a side plate surrounding the rear plate. The side plate is located within a preset direction range in which the antenna radiator emits and receives RF signals. The coupling structure is disposed on one side of the side plate facing the antenna radiator, and the side plate acts as the dielectric substrate.

In an implementation, the battery cover includes a rear plate and a side plate surrounding the rear plate. The rear plate is located within a preset direction range in which the antenna radiator emits and receives RF signals. The coupling structure is disposed on one side of the rear plate facing the antenna radiator, and the rear plate acts as the dielectric substrate.

In an implementation, the electronic device further includes a screen, where the screen acts as the dielectric substrate.

In an implementation, the electronic device further includes a protective cover, where the protective cover is located within the preset direction range in which the antenna radiator emits and receives RF signals, the protective cover acts as the dielectric substrate.

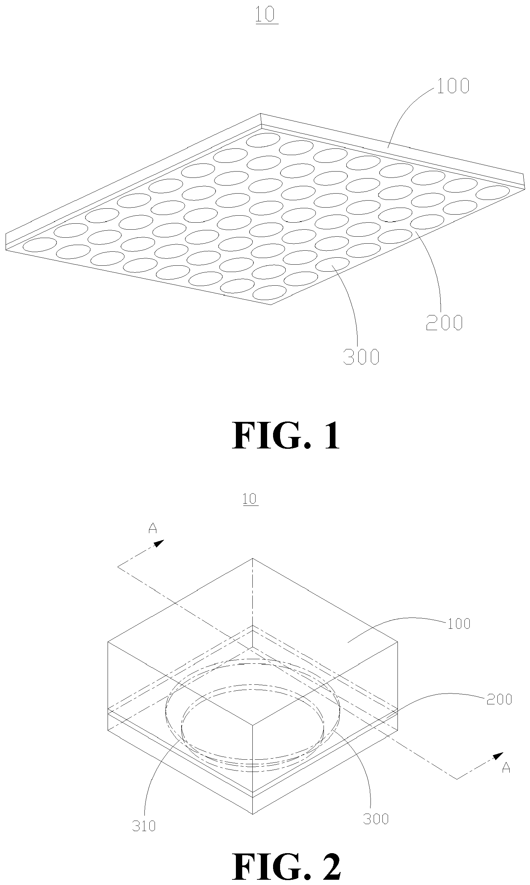

Referring to FIGS. 1 to 3, a housing assembly 10 is provided according to implementations of the disclosure. The housing assembly 10 includes a dielectric substrate 100, a bearing layer 200, and a coupling structure 300. The dielectric substrate 100 has a first transmittance to an RF signal in a preset frequency band. The bearing layer 200 is stacked with the dielectric substrate 100. The coupling structure 300 is disposed at the bearing layer 200. An orthographic projection of the coupling structure 200 on the dielectric substrate 100 at least partially covers the dielectric substrate 100. The coupling structure 300 includes one or more array layers 310 of coupling elements. The array layer 310 has resonance characteristics in the preset frequency band. The housing assembly 10 has a second transmittance to the RF signal in the preset frequency band in a region corresponding to the coupling structure 300. The second transmittance is greater than the first transmittance.

The RF signal can penetrate the dielectric substrate 100 and the bearing layer 200. The RF signal can be a millimeter wave signal. The dielectric substrate 100 is used for spatial impedance matching of the RF signal. The dielectric substrate 100 has the first transmittance to the RF signal in the preset frequency band. The bearing layer 200 is located on one side of the dielectric substrate 100 and is used to carry the coupling structure 300. The coupling structure 300 includes the one or more array layers 310 of coupling elements. The array layer 310 has resonance characteristics in the preset frequency band, which is used to make the RF signal resonate, so that the RF signal has a higher transmittance. As such, the housing assembly 10 has the second transmittance to the RF signal in the preset frequency band in the region corresponding to the coupling structure 300, the second transmittance is greater than the first transmittance. In other words, the resonance characteristics of the array layer 310 make the RF signal have a higher transmittance in the region of the housing assembly 10 corresponding to the coupling structure 300. When the coupling structure 300 is within a radiation direction range of an antenna, a radiation gain of the antenna can be improved.

In an implementation, the coupling structure 300 includes one array layer 310 disposed at the bearing layer 200 to improve a transmittance of the housing assembly 10 to the RF signal in the preset frequency band.

In an example, the array layer 310 has a single-layer structure. The array layer 310 can be connected to the bearing layer 200 via a connecting member. The connecting member may be an adhesive. The array layer 310 has the resonance characteristics to the RF signal in the preset frequency band, which can enable the RF signal in the preset frequency band to resonate, thereby allowing the RF signal in the preset frequency band to have an improved transmittance.

In another implementation, the orthographic projection of the coupling structure 300 on the dielectric substrate 100 covers the entire dielectric substrate 100. In other words, the bearing layer 200 covers the entire dielectric substrate 100. The coupling structure 300 is carried on the bearing layer 200, and is arranged corresponding to the entire dielectric substrate 100. In other words, the entire housing assembly 10 has a high transmittance to the RF signal in the preset frequency band. In this implementation, the orthographic projection of the coupling structure 300 on the dielectric substrate 100 covers the entire dielectric substrate 100, which is beneficial to reducing the complexity of the manufacturing process of the housing assembly 10.

In another implementation, the orthographic projection of the coupling structure 300 on the dielectric substrate 100 partially covers the dielectric substrate 100. In this implementation, an area covered by the coupling structure 300 is smaller than the area of the dielectric substrate 100, such that the coupling structure 300 is disposed corresponding to a part of the dielectric substrate 100. In this way, the housing assembly 10 has different transmittances to the RF signal in the preset frequency band in different regions of the housing assembly 10, which is beneficial to flexibly setting the housing assembly 10 according to transmittances to the RF signal in the preset frequency band.

According to implementations of the disclosure, the housing assembly 10 is provided. The housing assembly 10 includes the dielectric substrate 100, the bearing layer 200, and the coupling structure 300. The dielectric substrate 100 has the first transmittance to the RF signal in the preset frequency band. The bearing layer 200 is stacked with the dielectric substrate 100. The coupling structure 300 is disposed at the bearing layer 200. The orthographic projection of the coupling structure 200 on the dielectric substrate 100 at least partially covers the dielectric substrate 100. The coupling structure 300 includes one or more array layers 310 of coupling elements. The array layer 310 has resonance characteristics in the preset frequency band. The housing assembly 10 has a second transmittance to the RF signal in the preset frequency band in the region corresponding to the coupling structure 300. The second transmittance is greater than the first transmittance. The housing assembly 10 in the implementations of the disclosure is provided with the coupling structure 300 at a preset position of the dielectric substrate 100. The coupling structure 300 has one or more array layers 310 of coupling elements. The array layer 310 has the resonance characteristics in the preset frequency band, and with aid of the resonance characteristics, the transmittance of the housing assembly 10 to the RF signal in the preset frequency band can be adjusted. In this way, the housing assembly 10 has different transmittances to the RF signal at different regions. When the housing assembly 10 is applied to an antenna, the radiation performance of the antenna can be changed.

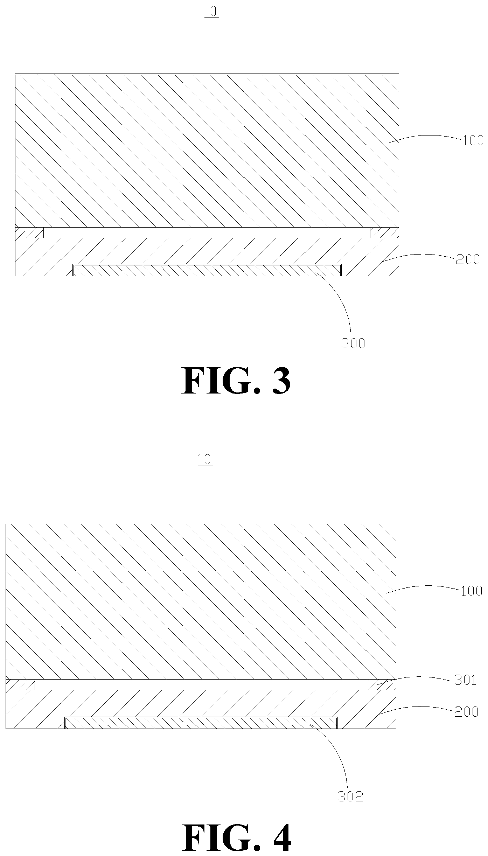

Referring to FIG. 4, the coupling structure 300 includes a first array layer 301 and a second array layer 302 spaced apart from the first array layer 301. The first array layer 301 and the second array layer 302 are each disposed at a respective one of two opposite sides of the bearing layer 200. The first array layer 301 is closer to the dielectric substrate 100 than the second array layer 302.

In some implementations, the first array layer 301 is disposed between the dielectric substrate 100 and the bearing layer 200. The second array layer 302 is disposed on one side of the bearing layer 200 away from the first array layer 301. At least one of the first array layer 301 and the second array layer 302 has resonance characteristics to the RF signal in the preset frequency band. In an example, the first array layer 301 has resonance characteristics to the RF signal in the RF band, which can cause the RF signal in the RF band to resonate, thereby improving the transmittance to the RF signal in the preset frequency band. In another examples, the second array layer 302 has resonance characteristics to the RF signal in the preset frequency band, which can cause the RF signal in the preset frequency band to resonate, thereby improving the transmittance to the RF signal in the preset frequency band. In another example, both the first array layer 301 and the second array layer 302 have resonance characteristics to the RF signal of the preset frequency band, which can cause the RF signal in the preset frequency band to resonate, thereby improving the transmittance to the RF signal in the preset frequency band.

In some implementations, a projection of the first array layer 301 on the bearing layer 20 and a projection of the second array layer 302 on the bearing layer 200 do not, at least in part, overlap. In other words, the first array layer 301 can be completely misaligned with the second array layer 302 in a thickness direction. Alternatively, the first array layer 301 can be partially misaligned with the second array layer 302 in the thickness direction. As such, mutual interference caused by the resonance characteristics of the first array layer 301 and the second array layer 302 can be reduced, which can improve stability of the RF signal passing through the housing assembly 10.

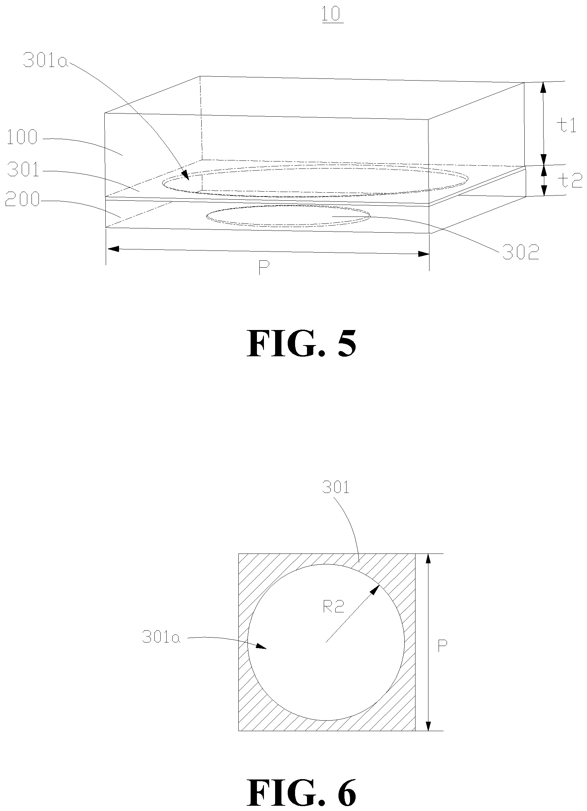

Referring to FIGS. 5 to 7, the first array layer 301 defines a through hole 301a, a projection of the second array layer 302 on the first array layer 301 falls into the through hole 301a.

In an implementation, the through hole 301a can have various shapes, including but not limited to, circle, oval, square, triangle, rectangle, hexagon, ring, cross, and Jerusalem cross. The first array layer 301 is a square patch. The second array layer 302 is a circular patch. The first array layer 301 has a side length *P* of 2.2 mm. The through hole 301a is a circular hole and has a radius *R2* of 1 mm. The second array layer 302 has a radius *R1* of 0.8 mm. The bearing layer 200 has a thickness *t2* of 0.2 mm The dielectric substrate 100 has a thickness *t1* of 0.55 mm.

In this example, the first array layer 301 can have the through hole 301a. The size of the through hole 301a can be greater than the size of the perimeter of the second array layer 302. The entire projection of the second array layer 302 on the first array layer 301 may fall within the through hole 301a. The RF signal in the preset frequency band can be transmitted through the through hole 301a of the first array layer 301 after being subjected to the resonance effect of the second array layer 302, thereby reducing interference of the first array layer 301 on the RF signal after being subjected to the resonance effect of the second array layer 302. In this way, stability of the RF signal transmission can be improved. Further, the first array layer 301 and the second array layer 302 together are used for spatial impedance matching of the RF signal in the preset frequency band, such that frequency adjustment can be implemented for the RF signal.

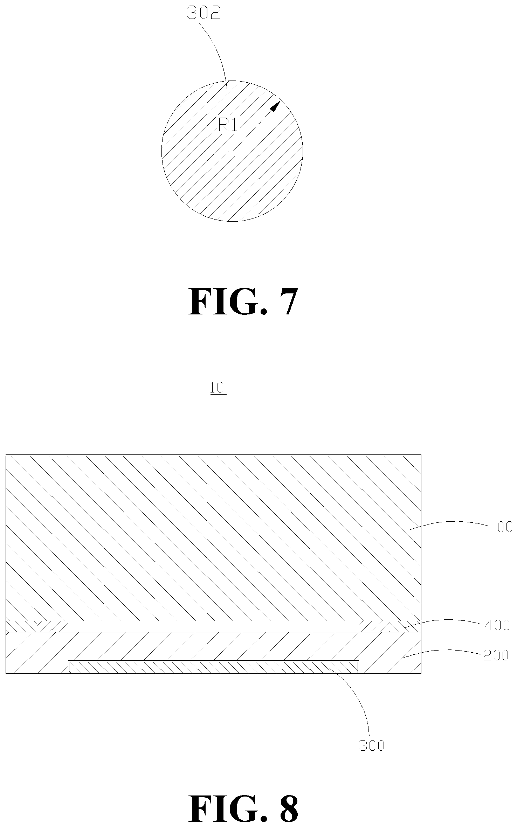

Referring to FIG. 8, an adhesive member 400 can be sandwiched between the dielectric substrate 100 and the bearing layer 200. The adhesive member 400 may fixedly connect the dielectric substrate 100 to the bearing layer 200.

The adhesive member 400 can be an adhesive, for example, an optical adhesive or a double-sided adhesive.

In one example, the adhesive member 400 is an integral layer of double-sided adhesive, i.e., the double-sided adhesive is a whole piece, and is used to fixedly connect the dielectric substrate 100 with the bearing layer 200, such that the dielectric substrate 100 and the bearing layer 200 are closely adhered to each other. This structure can help reduce interference on the transmittance to the RF signal in the preset frequency band, for example, caused by an air medium between the dielectric substrate 100 and the bearing layer 200.

In another example, the adhesive member 400 includes several adhesive units arranged at intervals. The adhesive units arranged at intervals can be arranged in array. The bearing layer 200 is adhered to the dielectric substrate 100 by using several adhesive units arranged at regular intervals. Since there is no direct contact between adjacent adhesive units, the internal stress generated between the adjacent adhesive units can be reduced or eliminated, further reducing or eliminating the internal stress between the bearing layer 200 and the dielectric substrate 100. Reducing the concentration of stresses between the bearing layer 200 and the dielectric substrate 100, the service life of the housing assembly 10 may be extended.

Furthermore, adjacent adhesive units, which are disposed corresponding to the edge of the dielectric substrate 100, can be spaced apart from one another at a first spacing. Adjacent adhesive units, which are disposed corresponding to the middle of the dielectric substrate 100, can be spaced apart from one another at a second spacing. The first spacing can be larger than the second spacing. Stress concentration can be higher and/or more likely to be present when the edge of the dielectric substrate 100 is bonded to the bearing layer 200. Therefore, when the first spacing between the adjacent adhesive units (corresponding to the edge of the dielectric substrate 100) is larger than the second spacing between the adjacent adhesive units (corresponding to the middle of the dielectric substrate 100), stress concentration between the adhesive units disposed at the edge of the dielectric substrate 100 can be reduced, and the stress concentration when the edge of the dielectric substrate 100 is bonded to the bearing layer 200 can be further improved.

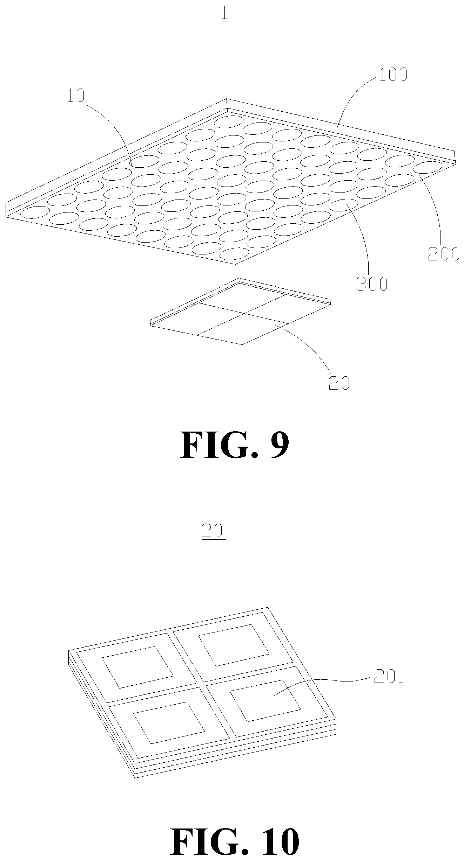

Referring to FIG. 9 and FIG. 10, the antenna device 1 includes an antenna module 20 and the housing assembly 10 of any of the above implementations. The antenna module 20 is spaced apart from the coupling structure 300 and includes at least one antenna radiator 201. The coupling structure 300 is at least partially located within a preset direction range in which the antenna radiator 201 emits and receives the RF signal, to match a frequency of the RF signal.

In an example, a distance between the coupling structure 300 and the antenna module 20 ranges from 0.5 mm to 2 mm. The antenna radiator 201 can be a millimeter wave antenna. The RF signal can be a millimeter wave signal.

In this implementation, the antenna module 20 is spaced parted from the coupling structure 300. The antenna module 20 is located on one side of the coupling structure 300 away from the dielectric substrate 100. The antenna radiator 201 may include one antenna radiator 201. Alternatively, the antenna radiator 201 may be an antenna array including multiple antenna radiators 201. The antenna module 20 can be a 2×2 antenna array, a 2×4 antenna array, or a 4×4 antenna array. In a case that the antenna module 20 includes multiple antenna radiators 201, the multiple antenna radiators 201 can work in the same frequency band. The multiple antenna radiator 201 can also work in different frequency bands, which helps to expand the frequency range of antenna module 20.

Further, the coupling structure 300 is at least partially located within the preset direction range for emitting and receiving RF signals by the antenna radiator 201, so as to match a frequency of the RF signal emitted and received by the antenna radiator 201. In a case that the coupling structure 300 is located within the preset direction range for transmitting and receiving the RF signal by the antenna radiator 201, the resonance characteristics of the coupling structure 300 can enable the RF signal to have resonance characteristics. As such, the transmittance of the housing assembly 10 to the RF signal emitted and received by the antenna radiator 201 is improved. In other words, the coupling structure 300 enables the radiation efficiency of the antenna radiator 201 in a corresponding frequency band to be improved.

In an implementation, the antenna radiator 201 is disposed at one side of the coupling structure 300 away from the dielectric substrate 100. The RF signal after frequency matching by the coupling structure 300 is capable of penetrating the dielectric substrate 100 to radiate in a direction away from the antenna radiator 100.

In this implementation, once the RF signal generated by the antenna radiator 201 reaches a surface of the coupling structure 300, the resonance characteristics of the coupling structure 300 can allow the RF signal to have a secondary resonance, thereby improving the transmittance of the housing assembly 10 to the RF signal. In this way, the dielectric substrate 100 can have an improved transmittance to the RF signal. With such structural arrangement, the radiation gain of the antenna radiator 201 can be improved, and the performance of the antenna radiator 201 can be enhanced.

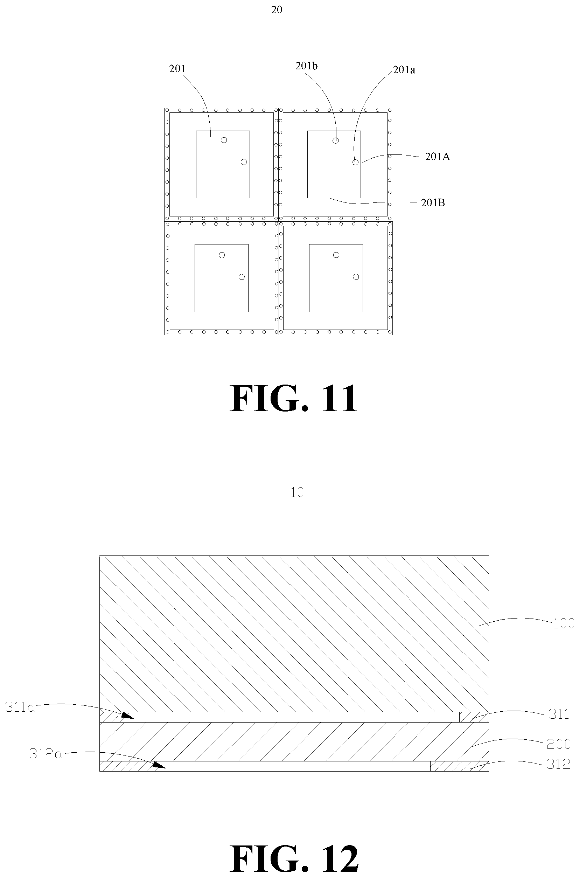

Referring to FIG. 11, the antenna radiator 201 has a first feed point 201a and a second feed point 201b. The first feed point 201a is configured to feed a first current signal to the antenna radiator 201. The first current signal is used to excite the antenna radiator 201 to resonate in a first frequency band to emit and receive the RF signal in the first frequency band. The second feed point 201b is configured to feed a second current signal to the antenna radiator 201. The second current signal is used to excite the antenna radiator 201 to resonate in a second frequency band, and the first frequency band is different from the second frequency band.

The first frequency band can be a high-frequency signal, and the second frequency band can be a low-frequency signal. Alternatively, the first frequency band can be a low-frequency signal, and the second frequency band can be a high-frequency signal.

According to the specification of the 3GPP TS 38.101, two frequency ranges are mainly used in 5G: FR1 and FR2. The frequency range corresponding to FR1 is 450 MHz~6 GHz, also known as the sub-6 GHz; the frequency range corresponding to FR2 is 24.25 GHz~52.6 GHz, usually called millimeter wave (mm Wave). 3GPP (version 15) specifies the present 5G millimeter wave as follows: n257 (26.5~29.5 GHz), n258 (24.25~27.5 GHz), n261 (27.5~28.35 GHz), and n260 (37~40 GHz). The first frequency band can be Band n257, and meanwhile the second frequency band can be Band n258, Band n260, or Band n261.

The antenna radiator 201 may be a rectangular patch antenna with a long side 201A and a short side 201B. The first feed point 201a is disposed on the long side 201A of the antenna radiator 201 to emit and receive the RF signal in the first frequency band. The RF signal in the first frequency band is a low-frequency signal. The second feed point 201b is disposed on the short side 201B of the antenna radiator 201 to emit and receive the RF signal in the second frequency band. The RF signal in the second frequency band is a high-frequency signal. The long side 201A and short side 201B of the antenna radiator 201 are used to change an electrical length of the antenna radiator 201, thereby changing the frequency of the RF signal emitted by the antenna radiator 201.

Referring to FIG. 12, the array layer 310 includes a first sub-array layer 311 and a second sub-array layer 312. The first sub-array layer 311 defines a first through hole 311a. The second sub-array layer 312 defines a second through hole 321a. When the first sub-array layer 311 and the second sub-array layer 312 are both located within the preset direction range in which the antenna radiator 201 emits and receives the RF signal and the first through hole 311a and the second through hole 312a are different in size, such that the RF signal emitted by the antenna radiator 201 after passing through the first through hole 311a has a bandwidth different from that of the RF signal emitted by the antenna radiator 201 after passing through the second through hole 312a.

In an implementation, when the radial size of the first through hole 311a is greater than the radial size of the second through hole 312a, the bandwidth of the RF signal emitted by the antenna radiator 201 after passing through the first through hole 311a can be greater than the bandwidth of the RF signal emitted by the antenna radiator 201 after passing through the second through hole 312a. In other words, the bandwidth of the RF signal after passing through the first through hole 311a or the second through hole 312a may be positively related to the radial size of the first through hole 311a or the second through hole 312a. When the radial size of the first through hole 311a is greater than the radial size of the second through hole 312a, the bandwidth of the RF signal after passing through the first through hole 311a is greater than the bandwidth of the RF signal after passing through the second through hole 312a. Thus, by controlling the radial size of the first through hole 311a of the first sub-array layer 311 and the radial size of the second through hole 312a of the second sub-array layer 312, the bandwidth of the RF signal can be adjusted, which can make the RF signal cover various, or all, 5G bands.

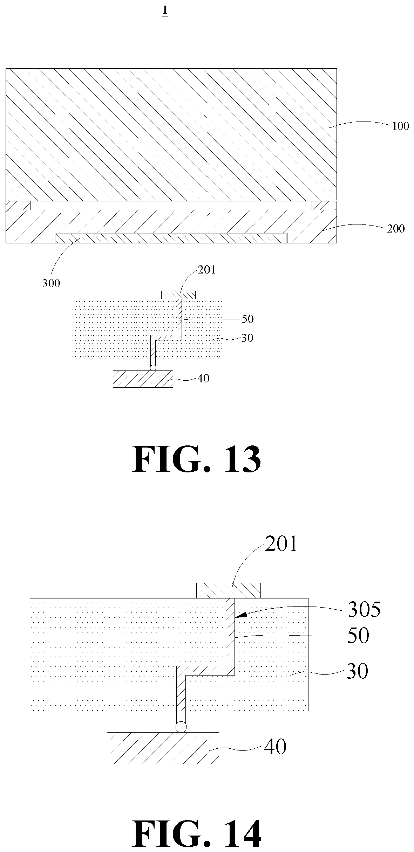

Referring to FIG. 13, the antenna device 1 includes a support plate 30 and an RF chip 40. The antenna radiator 201 is located on a surface of the support plate 30 close to the coupling structure 300. The RF chip 40 is located at a surface of the support plate 30 away from the coupling structure 300. The antenna device 1 further includes an RF line 50, and the RF line 50 is used to electrically couple the RF chip 40 with the antenna radiator 201.

The support plate 30 can be prepared by performing a high density inverter (HDI) process on a multilayer printed circuit board (PCB). The RF chip 40 is located at a side of the support plate 30 away from the antenna radiator 201. The antenna radiator 201 has at least one feed point which is used to receive an RF signal from the RF chip 40, such that RF signals in different frequency bands can be generated.

Additionally, positioning the antenna radiator 201 on the surface of the support plate 30 close to the coupling structure 300 can make the RF signal generated by the antenna radiator 201 transmit towards the coupling structure 300. Because the coupling structure 300 has the resonance characteristics, the RF signal has stronger penetrability after being subjected to the resonance effect of the coupling structure 300 which can enhance the radiation gain of the antenna radiator 201. Moreover, the RF chip 40 is located on the surface of the support plate 30 away from the coupling structure 300, which can reduce unnecessary interference of the RF chip 40 on the coupling structure 300, thereby facilitating stable resonance characteristics of the coupling structure 300 and stable radiation characteristics of the antenna radiator 201.

Referring to FIG. 14, the support plate 30 defines a limiting hole 305, and the RF line 50 is located in the limiting hole 305.

The support plate 30 has the limiting hole 305. The RF line 50 is received in the limiting hole 305. The RF line 50 can have one end electrically connected with the antenna radiator 201 and the other end electrically connected with the RF chip 40. The RF signal generated by the RF chip 40 is transmitted to the antenna radiator 201 via the RF line 50.

In order to electrically connect the RF chip 40 and the antenna radiator 201, the limiting hole 305 needs to be provided on the support plate 30. The RF line 50 is disposed in the limiting hole 305 to electrically connect the antenna radiator 201 and the RF chip 40. Therefore, the RF signal on the RF chip 40 is transmitted to the antenna radiator 201, and then the antenna radiator 201 generates the RF signal according to the RF signal.

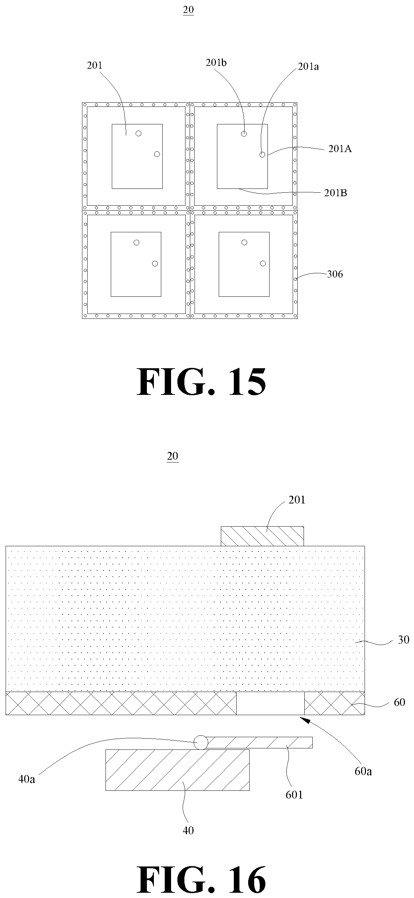

Referring to FIG. 15, the support plate 30 has multiple metallized vias 306. The multiple metallized vias 306 are arranged around the antenna radiator 201 to isolate two adjacent antenna radiators 210.

In this example, there are several uniformly arranged metallized vias 306 on the support plate 30, which surround the antenna radiator 201. The metallized vias 306 can be provided to achieve isolation and decoupling in the antenna module 20. That is, due to the presence of the metallized vias 306, radiation interference between adjacent two antenna radiators 200 due to mutual coupling can be prevented, and the antenna radiator 201 can be ensured to be in a stable working state.

Referring to FIG. 16, the antenna device 1 further includes a feed ground layer 60. The antenna radiator 201 is disposed on the surface of the support plate 30 close to the coupling structure 300. The RF chip 40 is disposed on the surface of the support plate 30 away from the coupling structure 300. The feed ground layer 60 is located between the support plate 30 and the RF chip 40. The feed ground layer 60 serves as a ground electrode of the antenna radiator 201. The feed ground layer 60 defines an aperture 60a. A feed line 601 is disposed between the RF chip 40 and the feed ground layer 60. The feed line 601 is electrically coupled with the RF chip 40. A projection of the feed line 601 on the feed ground layer 60 at least partially falls into the aperture 60a. The feed line 601 is configured to couple and feed on the antenna radiator 201 via the aperture 60a.

The RF chip 40 has an output end 40a, where the output end 40a can be used to generate an RF signal. The RF signal generated by the RF chip 40 is transmitted to the feed line 601. The feed line 601 is disposed corresponding to the aperture 60a of the feed ground layer 60. Thus, the feed line 601 can transmit, via the aperture 60a, the RF signal received to the feed point of the antenna radiator 201 through coupling. The antenna radiator 201 is coupled to the RF signal from the feed line 601 to generate the RF signal in the preset frequency band.

Furthermore, the feed ground layer 60 serves as the ground electrode of the antenna radiator 201. The antenna radiator 201 does not need to be electrically connected with the feed ground layer 60 directly, but the antenna radiator 201 is grounded by coupling. The projection of the feed line 601 on the feed ground layer 60 is at least partially within the aperture 60a, so that the feed line 601 can conduct coupling feed on the antenna radiator 201 via the aperture 60a.

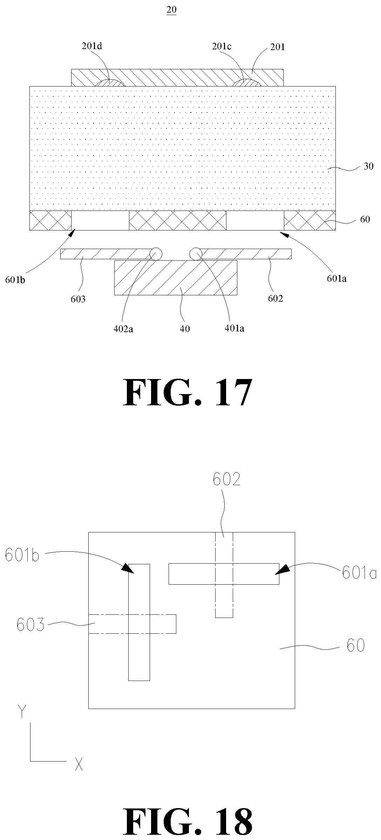

FIG. 17 and FIG. 18 depict other examples where the RF chip 40 has a first output end 401a and a second output end 402a. The first output end 401a is used to generate a first RF signal. The second output end 402a is used to generate a second RF signal. The first RF signal generated by the RF chip 40 is transmitted to a first sub-feed line 602. The first sub-feed line 602 is disposed corresponding to a first aperture 601a of the feed ground layer 60. Thus, the first sub-feed line 602 can transmit, via the first aperture 601a, the first RF signal received to a first sub-feed point 201c of the antenna radiator 201 in a coupling manner. The antenna radiator 201 is coupled to the first RF signal from the first sub-feed line 602 to generate an RF signal in a first frequency band. The second sub-feed line 602 is disposed corresponding to a second aperture 602a of the feed ground layer 60. Thus, the second sub-feed line 603 can transmit, via the second aperture 602a, the second RF signal received to a second sub-feed point 201d of the antenna radiator 201 in a coupling manner. The antenna radiator 201 is coupled to the second RF signal from the second sub-feed line 603 to generate an RF signal in a second frequency band. When the first RF signal is different from the second RF signal, the antenna module 20 can work in multiple frequency bands, widening the frequency range of the antenna module 20. In this way, the use range of the antenna module 20 can be adjusted flexibly.

Furthermore, the feed ground layer 60 serves as the ground electrode of the antenna radiator 201. The antenna radiator 201 and the feed ground layer 60 do not need to be electrically connected directly, but the antenna radiator 201 is grounded by coupling. The projection of the first sub-feed line 602 on the feed ground layer 60 is at least partially within the first aperture 601a, and the projection of the second sub-feed line 603 on the feed ground layer 60 is at least partially within the second aperture 602a. It is convenient for the first sub-feed line 602 to conduct coupling feed on the antenna radiator 201 via the first aperture 601a and for the second sub-feed line 603 to conduct coupling feed on the antenna radiator 201 via the second aperture 602a.

Furthermore, in an example, the first aperture 601a extends in a first direction and the second aperture 602a extends in a second direction, where the first direction is perpendicular to the second direction.

In an example, both the first aperture 601a and the second aperture 602a can be strip slots. The first aperture 601a can be a vertical polarized slot or a horizontal polarized slot. The second aperture 602a can be a vertical polarized slot or a horizontal polarized slot. When the first aperture 601a is a vertical polarized slot, the second aperture 602a is a horizontal polarized slot. When the first aperture 601a is a horizontal polarized slot, the second aperture 602a is a vertical polarized slot. An example in which an extending direction of the first aperture 601a is the Y direction and an extending direction of the second aperture 602a is the X direction is taken in the disclosure. When the extending direction of the first aperture 601a is perpendicular to the extending direction of the second aperture 602a, the feed ground layer 60 is a feed ground layer with a bipolar (or a dual-polarized) aperture. In this case, the antenna module 20 is a bipolar antenna module. Thus, the radiation direction of the antenna module 20 can be adjusted, which in turn can achieve targeted radiation, increasing the gain of radiation of the antenna module. The "polarization of the antenna" may refers to a direction of the electric field strength in which the antenna radiates an electromagnetic wave. When the direction of the electric field strength is perpendicular to the ground, this electromagnetic wave is called a vertical polarized wave; and when the direction of the electric field strength is parallel to the ground, this electromagnetic wave is called a horizontal polarized wave. Due to the characteristics of the RF signal, a signal propagated through horizontal polarization manner will produce a polarization current on the ground surface when the signal is close to the ground. The polarization current generates thermal energy influenced by the earth impedance, which causes the electric field signal to decay rapidly. With the vertical polarization manner, significant effort is required to produce the polarization current, avoiding rapid attenuation of energy and ensuring the effective propagation of the signal. Therefore, in the mobile communication system, the vertical polarized propagation manner is generally adopted. The bipolar antenna generally can have two configurations: vertical and horizontal polarization and ± 45° polarization, and the latter can generally be superior to the former in performance. Thus, ± 45° polarization is more widely adopted. The bipolar antenna combines + 45° and -45° antennas with mutually orthogonal polarization directions, and works simultaneously in a duplex mode (for example, a receive/transmit mode), which can save the number of antennas in each cell. Moreover, because ± 45° are orthogonal polarization directions, the positive effects of diversity reception can be provided (e.g. its polarization diversity gain can be about 5d, which may be about 2d higher than that of a single-polarized antenna).

Furthermore, the extending direction of the first aperture 601a is perpendicular to an extending direction of the first sub-feed line 602, and the extending direction of the second aperture 602a is perpendicular to an extending direction of the second sub-feed line 603.

In this example, the first aperture 601a and the second aperture 602a are both strip shots. The first sub-feed line 602 is spaced apart from the feed ground layer 60. The second sub-feed line 603 is spaced apart from the feed ground layer 60. The projection of the first sub-feed line 602 on the feed ground layer 60 is at least partially within the first aperture 601a. The projection of the second sub-feed line 603 on the feed ground layer 60 is at least partially within the second aperture 602a. The extending direction of the first sub-feed line 602 is perpendicular to the extending direction of the first aperture 601a, and the extending direction of the second sub-feed line 603 is perpendicular to the extending direction of the second aperture 602a. In this way, the coupling feed effect of the dual-polarized antenna module 20 can be improved, thereby improving the radiation efficiency of the antenna module 20 and improving the radiation gain.

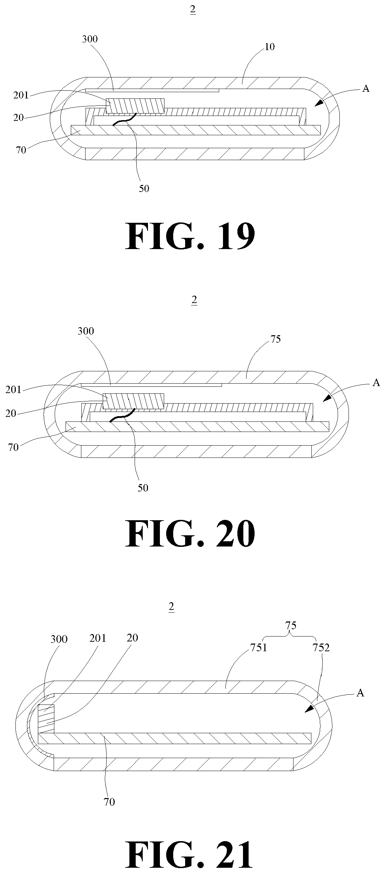

Referring to FIG. 19, an electronic device 2 is provided. The electronic device 2 includes a mainboard 70, an antenna module 20, and the housing assembly 10 of any of the above implementations. The mainboard 70 is received in the housing assembly 10. The housing assembly 10 defines an accommodating space A at one side of the housing assembly 10 facing the coupling structure 300. The antenna module 20 is received in the accommodating space A and electrically coupled to the mainboard 70. The antenna module 20 includes at least one antenna radiator 201. The mainboard 70 is configured to control the antenna radiator 201 to emit and receive RF signals which pass through the housing assembly 10.

In this implementation, the electronic device 2 can be any device with communication and storage functions, for example, tablet computers, mobile phones, e-readers, remote controllers, personal computers (PC), notebook computers, in-vehicle devices, network TVs, wearable devices, and other smart devices with network functions.

The mainboard 70 can be a PCB of the electronic device 2. The mainboard 70 and the housing assembly 10 cooperate to define the accommodating space A. The antenna module 20 is received in the accommodating space A and the antenna module 20 is electrically connected with the mainboard 70. The antenna module 20 may include one or more antenna radiators 201. Alternatively, the antenna module 20 may be an antenna array including multiple antenna radiators 201. Under the control of the mainboard 70, the antenna radiator 201 can emit and receive an RF signal through the antenna housing 100. Because the coupling structure 300 has resonance characteristics, the RF signal can have resonance characteristics to enhance the penetrability of the RF signal. The RF signal has a higher transmittance when passing through the housing assembly 10.

Referring to FIG. 20, the electronic device 2 further includes a battery cover 75. In this case, the battery cover 75 acts as the dielectric substrate 100. The battery cover 75 can be made of any one or more of plastic, glass, sapphire, and ceramic.

In detail, in the structural arrangement of the electronic device 2, at least a part of the battery cover 75 is located within a preset direction range of receiving/transmitting an RF signal by the antenna radiator 201. Therefore, the battery cover 75 will also affect the radiation characteristics of the antenna radiator 201. As such, in this implementation using the battery cover 75 as the dielectric substrate 100 can make the antenna radiator 201 have stable radiation performance in the structural arrangement of the electronic device 2. At this case, the battery cover 75 can be made of a wave-transparent material. The battery cover 75 can be made of any one of more of plastic, glass, sapphire, and ceramic.

Referring to FIG. 21, the battery cover 75 includes a rear plate 751 and a side plate 752 surrounding the rear plate 751. When the side plate 752 is located in a preset direction range in which the antenna radiator 201 emits and receives RF signals. The coupling structure 300 is disposed on one side of the side plate 752 facing the antenna radiator 201. In this case, the side plate 752 acts as the dielectric substrate 100.

In detail, when the antenna radiator 201 faces the side plate 752 of the battery cover 75, the side plate 752 can be used for spatial impedance matching of the RF signal emitted/transmitted by the antenna module 20. In this case, the side plate 752 acts as the dielectric substrate 100. The coupling structure 300 is disposed on the side of the side plate 752 facing the antenna radiator 201. The coupling structure 300 has resonance characteristics to the RF signal in the preset frequency band, which can cause the RF signal to have resonance characteristics. In this way, the RF signals emitted/ received by the antenna radiator 201 can pass through the side plate 752. The side plate 752 can act as the dielectric substrate 100 for spatial impedance matching of the antenna radiator 201, as such, the arrangement of the antenna radiator 201 in the entire electronic device 1 is taken into consideration. In this way, the radiation effect of the antenna radiator 201 in the entire electronic device can be ensured.

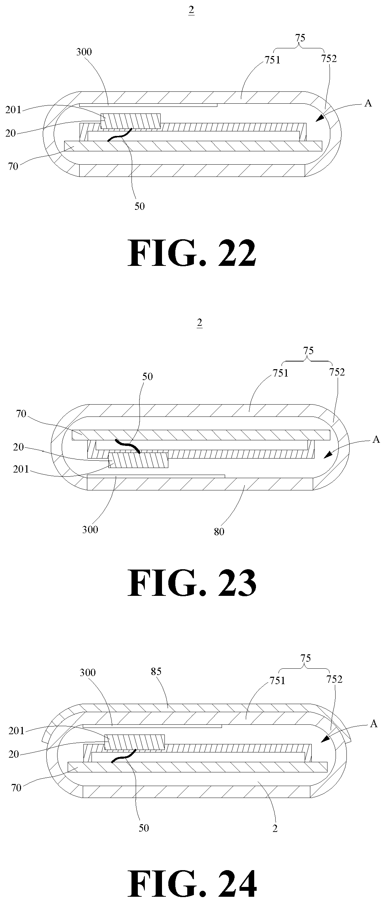

Referring to FIG. 22, the battery cover 75 includes a rear plate 751 and a side plate 752 surrounding the rear plate 751. The rear plate 751 is located within a preset direction range in which the antenna module 20 emits and receives RF signals. The coupling structure 300 is disposed on one side of the rear plate 751 facing the antenna radiator 201. In this case, the rear plate 751 acts as the dielectric substrate 100.

In detail, when the antenna radiator 201 faces the rear plate 751 of the battery cover 75, the rear plate 751 can be used to for spatial impedance matching of the RF signal emitted/transmitted by the antenna radiator 201. In this case, the rear plate 751 acts as the dielectric substrate 100. The coupling structure 300 is disposed on the side of the rear plate 751 facing the antenna radiator 201. The coupling structure 300 has resonance characteristics to the RF signal in the preset frequency band, which can cause the RF signal to have resonance characteristics. In this way, the RF signals emitted/received by the antenna radiator 201 can pass through the rear plate 751. The rear plate 751 can act as the dielectric substrate 100 for spatial impedance matching of the antenna radiator 201, as such, the arrangement of the antenna radiator 201 in the entire electronic device 1 is taken into consideration. In this way, the radiation effect of the antenna radiator 201 in the entire electronic device can be ensured.

Referring to FIG. 23, the electronic device 2 further includes a screen 80 and the screen 80 acts as the dielectric substrate 100.

In detail, when the antenna radiator 201 faces the screen 80, the screen 80 can be used for perform spatial impedance matching of the RF signal emitted/transmitted by the antenna radiator 201. In this case, the screen 80 acts as the dielectric substrate 100. The coupling structure 300 is disposed on a side of the screen 80 facing the antenna radiator 201. The coupling structure 300 has resonance characteristics to the RF signal in the preset frequency band, which can cause the RF signal to have resonance characteristics. In this way, the RF signals emitted/received by the antenna radiator 201 can pass through the screen 80 for transmission. The screen 80 can act as the dielectric substrate 100 for spatial impedance matching of the antenna radiator 201, as such, the arrangement of the antenna radiator 201 in the entire electronic device 1 is taken into consideration. In this way, the radiation effect of the antenna radiator 201 in the entire electronic device can be ensured.

Referring to FIG. 24, the electronic device 1 further includes a protective cover 85. The protective cover 85 can be located within the preset direction range in which the antenna radiator 201 emits and receives RF signals. In this case, the protective cover 85 acts as the dielectric substrate 100.

In detail, when the antenna radiator 201 faces the protective cover 85 of the battery cover 75, the protective cover 85 can be used for spatial impedance matching of the RF signal emitted/transmitted by the antenna radiator 201. In this case, the protective cover 85 acts as the dielectric substrate 100. The coupling structure 300 is disposed on a side of the protective cover 85 facing the antenna radiator 201. The coupling structure 300 has resonance characteristics to the RF signal in the preset frequency band, which can cause the RF signal to have resonance characteristics. In this way, the RF signals emitted/received by the antenna radiator 201 can pass through the protective cover 85 for transmission. The protective cover 85 can act as the dielectric substrate 100 for spatial impedance matching of the antenna radiator 201. As such, the arrangement of the antenna radiator 201 in the entire electronic device 1 is taken into consideration. In this way, the radiation effect of the antenna radiator 201 in the entire electronic device can be ensured.

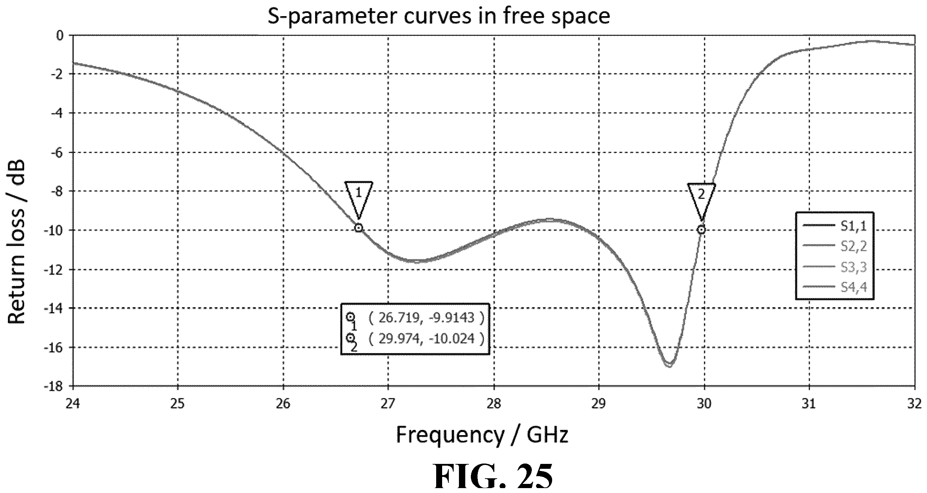

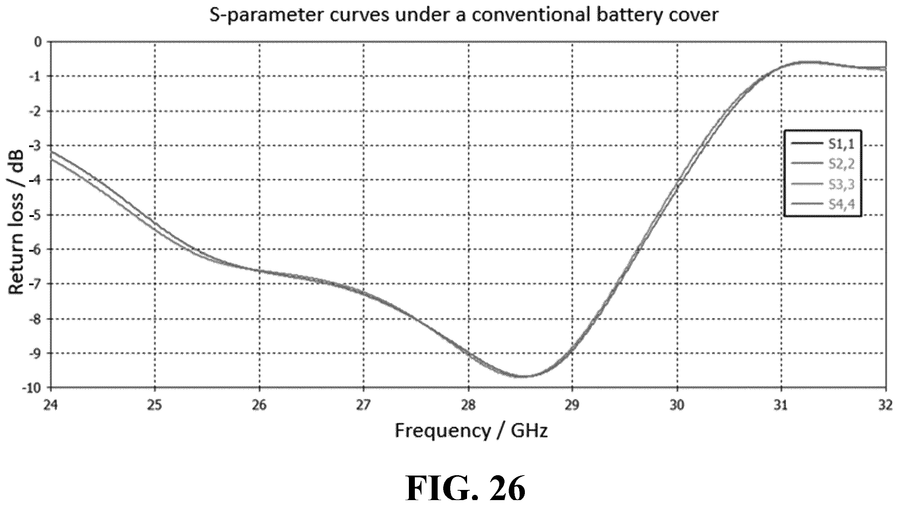

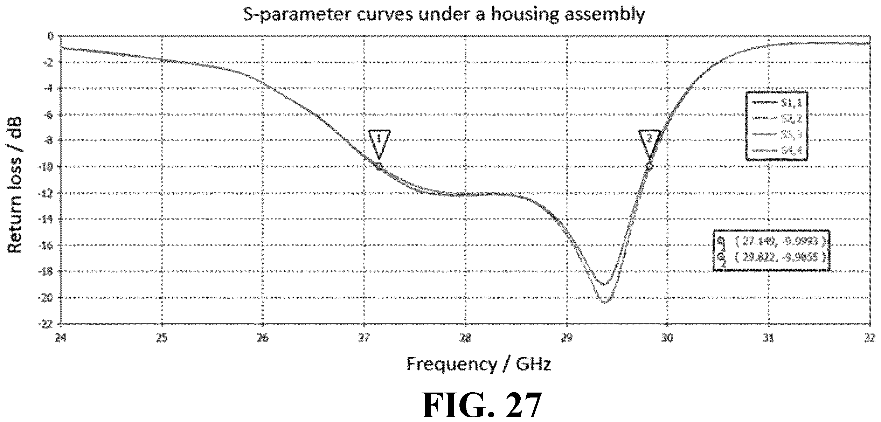

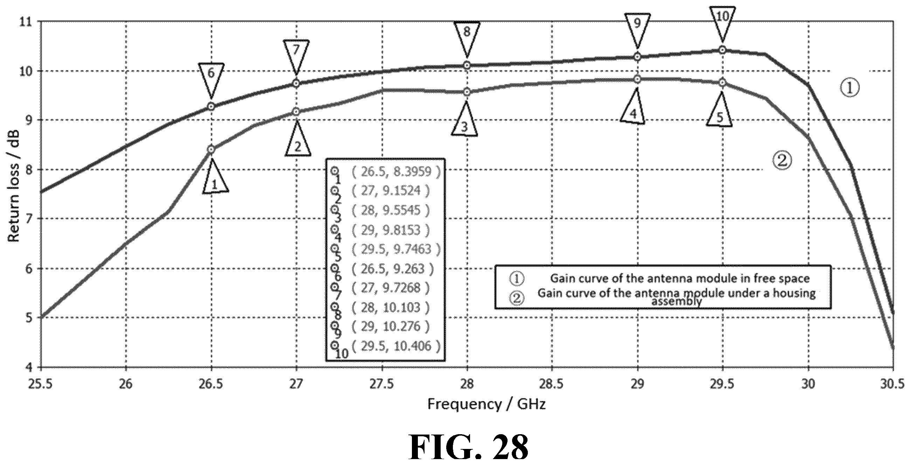

FIG. 25 is a schematic diagram of S-parameter curves of a 2×2 antenna module in free space. FIG. 26 is a schematic diagram of S-parameter curves of a 2×2 antenna module under a conventional glass battery cover. FIG. 27 is a schematic diagram of S-parameter curves of a 2×2 antenna module under the housing assembly 10. FIG. 28 is a schematic diagram of a gain curve of a 2×2 antenna module under the housing assembly 10.

It is clear that compared with conventional battery cover, if the housing assembly 10 is assembled, the antenna module has better impedance and gain. A distance between the antenna module 20 and the housing assembly 10 is greater than zero. In order to adapt to the stacking structural arrangement of the electronic device, in this implementation, the distance can range from 0.5 mm to 2 mm.

Referring to FIG. 25, S1,1, S2,2, S3,3, S4,4 respectively represent a return loss curve of each antenna radiator of the 2×2 antenna module. Due to a symmetry design of the 2×2 antenna module, the four curves of S1,1, S2,2, S3,3, S4,4 in FIG. 25 are substantially coincide with one another. In addition, two triangular marks 1 and 2 in FIG. 25 are each used to mark one frequency and the return loss of the frequency. Mark 1 indicates that the return loss is -0.60036 dB when the frequency is 26.719 GHz. Mark 2 indicates that the return loss is -10.024 dB when the frequency is 29.974 GHz. As illustrated in FIG. 25, the 2×2 antenna module has good radiation performance at frequencies between 26.719 GHz and 29.974 GHz.

Referring to FIG. 26, S1,1, S2,2, S3,3, S4,4 respectively represent a return loss curve of each antenna radiator of the 2×2 antenna module. Due to a symmetry design of the 2×2 antenna module, the four curves of S1,1, S2,2, S3,3, S4,4 in FIG. 26 are substantially coincide with one another.

Referring to FIG. 27, S1,1, S2,2, S3,3, S4,4 respectively represent a return loss curve of each antenna radiator of the 2×2 antenna module. Due to a symmetry design of the 2×2 antenna module, the four curves of S1,1, S2,2, S3,3, S4,4 in FIG. 27 are substantially coincide with one another. In addition, two triangular marks 1 and 2 in FIG. 27 are each used to mark one frequency and the return loss of the frequency. Mark 1 indicates that the return loss is -909993 dB when the frequency is 27.149 GHz. Mark 2 indicates that the return loss is -9.9855 dB when the frequency is 29.822 GHz. As illustrated in FIG. 27, the 2×2 antenna module has good radiation performance at frequencies between 27.149 GHz and 29.822 GHz.

In FIG. 38, the abscissa denotes the frequency (unit: GHz) and the ordinate denotes the return loss (unit: dB). Curve ① represents a gain curve of the antenna module 20 in free space. Curve ② represents a gain curve of the antenna module 20 under the housing assembly 10. On Curve ②, Mark 1 indicates that the gain of the antenna module is 8.3959 dB when the frequency is 26.5 GHz, Mark 2 indicates that the gain of the antenna module is 9.1524 dB when the frequency is 27 GHz, Mark 3 indicates that the gain of the antenna module is 9.5545 dB when the frequency is 28 GHz, Mark 4 indicates that the gain of the antenna module is 9.8153 dB when the frequency is 29 GHz, and Mark 5 indicates that the gain of the antenna module is 9.7463 dB when the frequency is 29.5 GHz. On Curve ①, Mark 6 indicates that the gain of the antenna module is 9.263 dB when the frequency is 26.5 GHz, Mark 7 indicates that the gain of the antenna module is 9.7268 dB when the frequency is 27 GHz, Mark 8 indicates that the gain of the antenna module is 10.103 dB when the frequency is 28 GHz, Mark 9 indicates that the gain of the antenna module is 10.276 dB when the frequency is 29 GHz, and Mark 10 indicates that the gain of the antenna module is 10.406 dB when the frequency is 29.5 GHz.

The implementations of the disclosure are described in detail above, specific examples are used herein to describe the principle and implementation manners of the disclosure. The description of the above implementations is merely used to help understand the method and the core idea of the disclosure. Meanwhile, those skilled in the art may make modifications to the specific implementation manners and the application scope according to the idea of the disclosure. In summary, the contents of the specification should not be construed as limiting the disclosure.

## Claims

1. A housing assembly, comprising:
a dielectric substrate having a first transmittance to a radio frequency (RF) signal in a preset frequency band;
a bearing layer stacked with the dielectric substrate; and
a coupling structure disposed at the bearing layer, wherein an orthographic projection of the coupling structure on the dielectric substrate at least partially covers the dielectric substrate, the coupling structure comprises one or more array layers of coupling elements, and the array layer has resonance characteristics in the preset frequency band;
wherein the housing assembly has a second transmittance to the RF signal in the preset frequency band in a region corresponding to the coupling structure, the second transmittance being greater than the first transmittance.

2. The housing assembly of claim 1, wherein the coupling structure comprises one array layer disposed at the bearing layer to increase a transmittance of the housing assembly to the RF signal in the preset frequency band.

3. The housing assembly of claim 1, wherein the coupling structure comprises a first array layer and a second array layer spaced apart from the first array layer, the first array layer and the second array layer are each disposed at a respective one of two opposite sides of the bearing layer, and the first array layer is closer to the dielectric substrate than the second array layer.

4. The housing assembly of claim 3, wherein a projection of the first array layer on the bearing layer and a projection of the second array layer on the bearing layer do not, at least in part, overlap.

5. The housing assembly of claim 4, wherein the first array layer defines a through hole, a projection of the second array layer on the first array layer falls into the through hole.

6. The housing assembly of claim 5, wherein the through hole is in a shape of circle, oval, square, triangle, rectangle, hexagon, ring, cross, or Jerusalem cross.

7. The housing assembly of claim 5, wherein
the first array layer is a square patch, and the second array layer is a circular patch;
the first array layer has a side length of 2.2 mm, the through hole is a circular hole and has a radius of 1 mm, and the second array layer has a radius of 0.8 mm; and
the bearing layer has a thickness of 0.2 mm, and the dielectric substrate has a thickness of 0.55 mm.

8. The housing assembly of claim 1, further comprising an adhesive member sandwiched between the dielectric substrate and the bearing layer, wherein the adhesive member fixedly connects the dielectric substrate to the bearing layer.

9. An antenna device, comprising an antenna module and the housing assembly of any of claims 1-8, wherein
the antenna module is spaced apart from the coupling structure and comprises at least one antenna radiator; and
the coupling structure is at least partially located within a preset direction range in which the antenna radiator emits and receives the RF signal, to match a frequency of the RF signal.

10. The antenna device of claim 9, wherein
the antenna radiator is disposed at one side of the coupling structure away from the dielectric substrate; and
the RF signal after frequency matching by the coupling structure is capable of penetrating the dielectric substrate to radiate in a direction away from the antenna radiator.

11. The antenna device of claim 9, wherein
the antenna radiator has a first feed point and a second feed point;
the first feed point is configured to feed a first current signal to the antenna radiator, the first current signal is used to excite the antenna radiator to resonate in a first frequency band to emit and receive the RF signal in the first frequency band; and
the second feed point is configured to feed a second current signal to the antenna radiator, the second current signal is used to excite the antenna radiator to resonate in a second frequency band, and the first frequency band is different from the second frequency band.

12. The antenna device of claim 9, wherein
the array layer comprises a first sub-array layer and a second sub-array layer, wherein the first sub-array layer defines a first through hole, the second sub-array layer defines a second through hole; and
the first sub-array layer and the second sub-array layer are both located within the preset direction range in which the antenna radiator emits and receives the RF signal, and the first through hole and the second through hole are different in size, such that the RF signal emitted by the antenna radiator after passing through the first through hole has a bandwidth different from that of the RF signal emitted by the antenna radiator after passing through the second through hole.

13. The antenna device of claim 12, wherein the first through hole has a radial size greater than the second through hole, the RF signal emitted by the antenna radiator after passing through the first through hole has a bandwidth greater than that of the RF signal emitted by the antenna radiator after passing through the second through hole.

14. The antenna device of claim 9, further comprising a support plate, an RF chip, and an RF line, wherein the antenna radiator is disposed on a surface of the support plate close to the coupling structure, the RF chip is disposed on a surface of the support plate away from the coupling structure, and the RF line electrically couples the RF chip with the antenna radiator.

15. The antenna device of claim 14, wherein the support plate defines a limiting hole, and the RF line is located in the limiting hole.

16. The antenna device of claim 14, wherein the support plate defines a plurality of metallized vias arranged around the antenna radiator to isolate two adjacent antenna radiators.

17. The antenna device of claim 9, further comprising a support plate, an RF chip, a feed ground layer, and a feed line, wherein
the antenna radiator is disposed on a surface of the support plate close to the coupling structure, the RF chip is disposed on a surface of the support plate away from the coupling structure;
the feed ground layer is located between the support plate and the RF chip and serves as a ground electrode of the antenna radiator;
the feed line is disposed between the RF chip and the feed ground layer, and the feed line is electrically coupled to the RF chip; and
the feed ground layer defines an aperture, a projection of the feed line on the feed ground layer at least partially falls into the aperture, and the feed line is configured to couple and feed the antenna radiator via the aperture.

18. The antenna device of claim 9, wherein a distance between the coupling structure and the antenna module ranges from 0.5 mm to 2 mm.

19. An electronic device, comprising a mainboard, an antenna module, and the housing assembly of any of claims 1-8, wherein
the mainboard is received in the housing assembly;
the housing assembly defines an accommodating space at one side of the housing assembly facing the coupling structure, the antenna module is received in the accommodating space and electrically coupled to the mainboard; and
the antenna module comprises at least one antenna radiator, the mainboard is configured to control the antenna radiator to emit and receive RF signals which pass through the housing assembly.

20. The electronic device of claim 19, further comprising a battery cover, wherein the battery cover acts as the dielectric substrate, the battery cover is made of one or more of plastic, glass, sapphire, and ceramic.

21. The electronic device of claim 20, wherein the battery cover comprises a rear plate and a side plate surrounding the rear plate, the side plate is located within a preset direction range in which the antenna radiator emits and receives RF signals, the coupling structure is disposed on one side of the side plate facing the antenna radiator, and the side plate acts as the dielectric substrate.

22. The electronic device of claim 20, wherein the battery cover comprises a rear plate and a side plate surrounding the rear plate, the rear plate is located within a preset direction range in which the antenna radiator emits and receives RF signals, the coupling structure is disposed on one side of the rear plate facing the antenna radiator, and the rear plate acts as the dielectric substrate.

23. The electronic device of claim 20, further comprising a screen, wherein the screen acts as the dielectric substrate.

24. The electronic device of claim 20, further comprising a protective cover, wherein the protective cover is located within a preset direction range in which the antenna radiator emits and receives RF signals, the protective cover acts as the dielectric substrate.
